# EUROPÄISCHE PATENTSCHRIFT

(11) **EP 1 090 418 B1**
(45) Veröffentlichungstag und Bekanntmachung des Hinweises auf die Patenterteilung: **09.07.2008**
(21) Anmeldenummer: 99934480.7
(22) Anmeldetag: 11.05.1999
(51) Int. Cl.: H01L 21/329, H01L 29/872

(54) **VERFAHREN ZUR HERSTELLUNG VON SCHOTTKY-DIODEN**
METHOD FOR PRODUCING SCHOTTKY DIODES
PROCEDE DE PRODUCTION DE DIODES SCHOTTKY

(30) Priorität: 26.05.1998 DE 19823481
(43) Veröffentlichungstag der Anmeldung: 11.04.2001
(73) Patentinhaber: Infineon Technologies AG, 81669 München (DE)
(72) Erfinder: LOSEHAND, Reinhard, D-80637 München (DE); WERTHMANN, Hubert, D-81247 München (DE)
(74) Vertreter: Ginzel, Christian
(86) Internationale Anmeldenummer: PCT/DE1999/001428
(87) Internationale Veröffentlichungsnummer: WO 1999/062112

(56) Entgegenhaltungen:
- WO-A-91/04581
- GB-A- 1 265 260
- US-A- 4 899 199
- PATENT ABSTRACTS OF JAPAN vol. 009, no. 325 (E-368), 20. Dezember 1985 (1985-12-20) -& JP 60 157268 A (ROOMU KK), 17. August 1985 (1985-08-17)
- PATENT ABSTRACTS OF JAPAN vol. 013, no. 240 (E-767), 6. Juni 1989 (1989-06-06) -& JP 01 042858 A (NEC CORP), 15. Februar 1989 (1989-02-15)

## Beschreibung

Die Erfindung betrifft ein Verfahren zur Herstellung von Schottky-Dioden, die im Randbereich des Schottky-Kontaktes einen Schutzring aufweisen.

Bei der Herstellung von sehr kleinflächigen Schottky-Dioden, das heißt von Schottky-Dioden mit einem Durchmesser der Größenordnung 5 bis 10 µm, bereitet die Beseitigung der Randeffekte erhebliche Schwierigkeiten. Es ist bekannt, diese Randeffekte mittels einem in Implantationstechnologie im Halbleitersubstrat bzw. in der zuobersten Epitaxieschicht eingebrachten dotierten Schutzring zu verringern. Bei sehr kleinflächigen Schottky-Dioden stellt jedoch ein mittels Fotomasken hergestellter dotierter Schutzring eine so erhebliche zusätzliche Kapazität dar, dass solchermaßen hergestellte Schottky-Dioden jedenfalls in höheren Frequenzbereichen nicht verwendet werden können. Für Anwendungen im 77 GHz-Frequenzbereich wird eine Gesamtkapazität der Schottky-Diode von etwa 40 fF gefordert, welche eine parasitäre Kapazität von höchstens 10 fF zulässt.

Schottky-Dioden mit Metallschutzringen sind in den Dokumenten WO 91/04581 und JP 60157268 offenbart.

Der Erfindung liegt die Aufgabe zugrunde, ein Verfahren zur Herstellung von Schottky-Dioden anzugeben, welche typische Durchmesser von 5 bis 10 µm besitzt und in Hochfrequenzbereichen von typischerweise 77 GHz und darüber eingesetzt werden kann.

Diese Aufgabe wird durch ein Verfahren nach Anspruch 1 gelöst.

Erfindungsgemäß ist vorgesehen, dass der Schutzring nach der Fertigung des Schottky-Kontaktes mittels Abscheiden eines elektrisch leitenden Schutzringmaterials auf die mit einer strukturierten Maskierungsschicht versehene Oberfläche der Halbleiterschicht hergestellt wird.

Dem Prinzip der Erfindung folgend stellt das Schutzringmaterial ein Metall, insbesondere ein Hoch-Barrieren-Metall dar, welches insbesondere Platin aufweist.

Zweckmäßigerweise wird das Schutzringmaterial durch Aufdampfen oder Aufsputtern aufgetragen.

Die strukturierte Maskierungsschicht wird vor dem Abscheiden des Schottky-Kontakt-Materials unter Verwendung einer strukturierten Abdeckschicht durch Unterätzung zurückgeätzt.

Vorteilhafte Weiterbildungen der Erfindung ergeben sich aus den Unteransprüchen.

Nachfolgend wird die Erfindung anhand von in der Zeichnung dargestellten Ausführungsbeispielen näher erläutert. Es zeigen:
- Figur 1: eine Halbleiterscheibe mit strukturierter Oxid- bzw. Nitridschichtmaske und Photolackmaske;
- Figur 2: eine Halbleiterscheibe nach Figur 1 nach dem Aufbringen des Schottkykontaktmaterials;
- Figur 3: die Halbleiterscheibe nach dem Abscheiden des Schutzringmaterials und nach Abscheiden und Strukturieren der Kontaktmetallisierungen;
- Figur 4: eine Halbleiterscheibe nach Figur 1 nach dem Aufdampfen des Schottky-Kontakt-Materials gemäß einem zweiten Ausführungsbeispiel der Erfindung;
- Figur 5: die Halbleiterscheibe nach Figur 4 nach Abscheiden des Schutzringmaterials; und
- Figur 6: die Halbleiterscheibe nach Figur 5 nach Abscheiden und Strukturieren der Kontaktmetallisierungen.

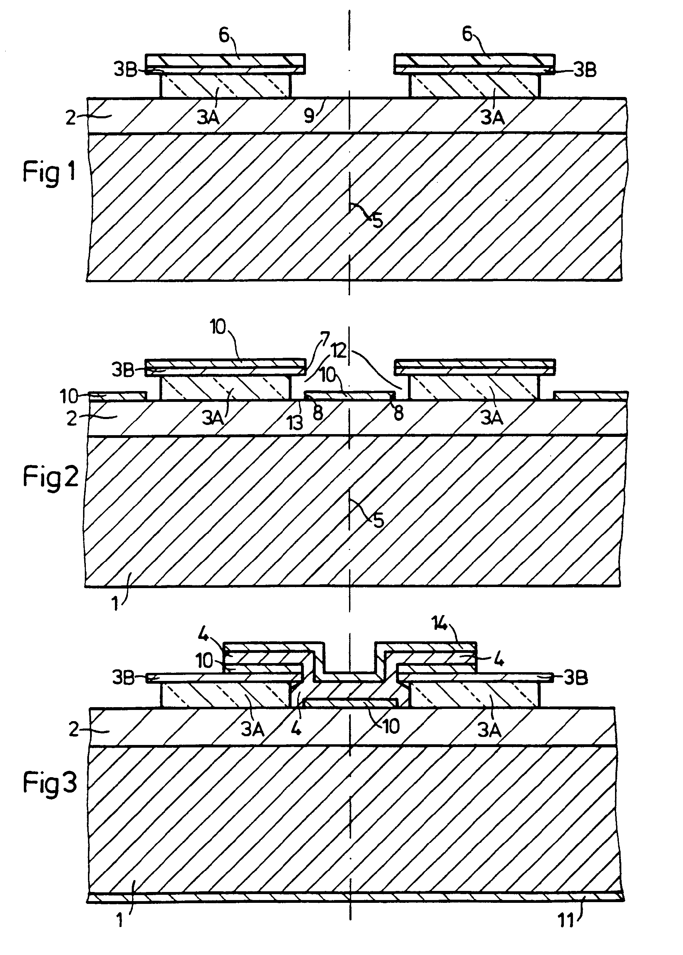

Figur 1 zeigt als Ausgangspunkt des erfindungsgemäßen Verfahrens nach den beiden Ausführungsbeispielen ein Substrat 1, das gewöhnlich aus Halbleitermaterial besteht, mit einer Halbleiterschicht 2, die epitaktisch darauf abgeschieden ist. Auf der epitaktisch abgeschiedenen Halbleiterschicht 2 ist eine Maskierungsschicht 3 bestehend aus einer etwa 0,2 µm starken Siliziumoxidschicht 3A und einer darauf unter geringem Druck abgeschiedenen, etwa 0,1 µm starken Low-Pressure-Siliziumnitrid-Schicht 3B. Zur Definition der aktiven Fläche der Schottky-Diode und zur Ätzung der Siliziumnitrid-Schicht 3B wird eine Fotolackschicht 6 in an sich bekannter Lithographietechnik strukturiert. Es folgt eine gezielte Unterätzung der Siliziumoxidschicht 3A mit ebenfalls bekannten Methoden, wobei der Wert der Unterätzung typischerweise maximal 0,2 µm beträgt. Die Bezugsziffer 5 bezeichnet die Symmetrieachse der rotationssymmetrisch ausgebildeten Schottky-Diode. Das Substrat 1 kann beispielsweise aus n⁺-dotiertem Silizium bestehen, während die Halbleiterschicht 2 aus n-dotiertem Silizium bestehen kann. Diese Materialwahl ist jedoch nicht zwingend. Substrat 1 und Halbleiterschicht 2 können auch die spiegelbildliche p-Dotierung aufweisen oder aus anderem Halbleitermaterial wie beispielsweise Germanium, Gallium-Arsenid oder Indiumphosphid bestehen. Die Maskierungschicht 3 kann aus einem beliebigen Isolator bestehen.

In den folgenden Figuren sind gleiche Gegenstände wie in Figur 1 beschrieben, mit gleichen Bezugszeichen belegt und werden deshalb nicht nochmals erläutert.

Figur 2 zeigt eine Halbleiterscheibe nach Figur 1, bei der nach Entfernen der Fotolackschicht 6 vermittels Lackstrippen ein Barrierenmetall 10 zur Ausbildung des Schottky-Kontaktes ganzflächig abgeschieden, insbesondere senkrecht zur Oberfläche 9 aufgedampft wurde. Die Stärke der Metallschicht 10 beträgt etwa maximal 0,1 µm. Ein geeignetes Metall für die Schicht 10 stellt beispielsweise Titan dar.

Daran anschließend wird ein Hoch-Barrieren-Metall 4 wie beispielsweise Platin isotrop aufgesputtert, wobei das Metall 4 durch den Spalt 12 zwischen der Nitridkante 7 und der Titankante 8 eindiffundiert und den offenen Siliziumring 13 zwischen der Titanschicht 10 und der Oxidschicht 3A bedeckt (Figur 3).

Es folgt eine Bedampfung mit einer Goldschicht 14 nach Figur 3, um gegebenenfalls den noch verbleibenden Spalt zwischen der Nitridkante 7 und der Titankante 8 aufzufüllen und eine bondbare Oberfläche herzustellen. Der sonach fertiggestellte und in Figur 3 in der Schnittansicht dargestellte Kontakt mit Gold ist auch unter der Bezeichnung Bell-Kontakt bekannt. Eine auf der Rückseite des Substrates 1 abgeschiedene Elektrodenschicht 11 bildet den zweiten Anschluss des Schottky-Kontaktes.

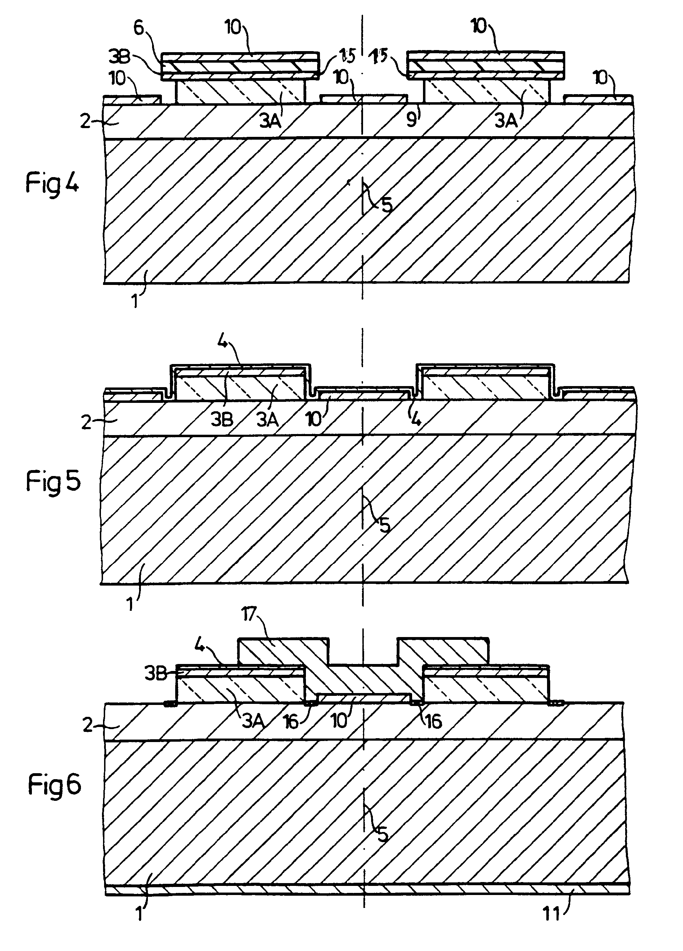

Die Figuren 4 bis 6 zeigen ein zweites Ausführungsbeispiel der Erfindung. Ausgehend von einer Anordnung nach Figur 1 wird nach Figur 4 ein Barrierenmetall 10 wie beispielsweise Titan in einer Stärke von typischerweise maximal 0,1 µm auf die Oberfläche 9 der Epi-Schicht 2 und die mit mit Photolack 6 bedeckte Maskierungsschicht 3 aufgebracht, vorzugsweise durch senkrechtes Aufdampfen. Daran anschließend erfolgt ein Abhebestrip, um den Fotolack 6 und das darauf befindliche Titanmaterial 10 zu entfernen. Es folgt eine Entfernung der überstehenden Nitridschicht-Krempen 15 vermittels Ätzen in heißer Phosphorsäure selektiv zum Titanmaterial 10.

Daran anschließend wird gemäß Figur 5 eine Hoch-Barrieren-Metall-Schicht 4 aus Platin isotrop aufgesputtert. Die zwischen der Titanschicht 10 und der Oxidschicht 3A befindlichen Platinbereiche 16 werden zur Ausbildung des Schutzringes siliziert. Es folgt ein Rücksputtern des Platins bis zur Nitridschicht 3B, wobei das Titan und das Platinsilizid 16 im Schutzring nur oberflächlich angesputtert werden.

Nach Aufdampfen und Strukturieren eines Bell-Kontaktes mit einer Schicht 17 bestehend beispielsweise aus Titanplatingold, und Abscheiden einer Elektrodenschicht 11 auf der Rückseite des Substrates 1 für den zweiten Anschluss ist der Schottky-Kontakt fertiggestellt.

Bei den beiden Ausführungsbeispielen nach Figur 3 und Figur 6 erfüllt das Hoch-Barrieren-Metall 4 aus Platin bzw. sein Silizid 16 die Anforderungen eines Schutzringes, weil es die Barrierenerniedrigung am Übergang des Schottky-Metalls 10 zum Oxid 3A kompensiert, die durch Verringerung der Grenzflächenzustandsdichten zum Oxid hin hervorgerufen wird. Die parasitäre Kapazität liegt bei Schottky-Dioden mit einem typischen Durchmesser von 5 µm bei etwa 5 fF (gemessen bei einer Spannung U = 0 V).

## Patentansprüche

1. Verfahren zur Herstellung von Schottky-Dioden, die im Randbereich eines auf einer Halbleiterschicht (2) ausgebildeten Schottky-Kontaktes einen durch eine Abscheidung von Metall hergestellten Schutzring aufweisen,
**dadurch gekennzeichnet, dass**
in einem ersten Schritt eine Maskierungsschicht (3A) hergestellt wird,
in einem zweiten Schritt eine Abdeckschicht (3B) auf die Maskierungsschicht hergestellt wird,
in einem dritten Schritt die Abdeckschicht strukturiert wird, wobei ein für den Schottky-Kontakt vorgesehener Bereich an der Oberfläche (9) der Halbleiterschicht (2) definiert wird,
in einem vierten Schritt die Maskierungsschicht durch Unterätzen zurückgeätzt wird, wobei der Bereich an der Oberfläche (9) der Halbleiterschicht (2) zwischen den übriggebliebenen Teilen der Maskierungsschicht freigelegt wird, in einem fünften Schritt ein für den Schottky-Kontakt vorgesehenes Barrierenmetall (10) ganzflächig abgeschieden wird, wobei ein Ring (13) an der Oberfläche (9) der Halbleiterschicht (2) zwischen der Maskierungsschicht (3A) und Kanten (8) des Barrierenmetalls (10) frei bleibt, und
in einem sechsten Schritt ein für den Schutzring vorgesehenes Hoch-Barrieren-Metall (4) abgeschieden wird, wobei der Ring (13) bedeckt wird.

2. Verfahren nach Anspruch 1,
**dadurch gekennzeichnet, dass**
in dem sechsten Schritt als Hoch-Barrieren-Metall (4) Platin aufgebracht wird.

3. Verfahren nach Anspruch 1 oder 2,
**dadurch gekennzeichnet, dass**
in dem sechsten Schritt das Hoch-Barrieren-Metall (4) in einer Stärke von etwa 0,1 µm aufgebracht wird.

4. Verfahren nach einem der Ansprüche 1 bis 3,
**dadurch gekennzeichnet, dass**
in dem ersten Schritt eine Siliziumoxidschicht (3A) und im zweiten Schritt darauf eine Siliziumnitridschicht (3B) aufgebracht und strukturiert werden, und dass im vierten Schritt durch die Unterätzung überstehende Nitridschicht-Krempen (15) gebildet werden.

5. Verfahren nach Anspruch 4,
**dadurch gekennzeichnet, dass**
die Siliziumoxidschicht (3A) mit einer Stärke von etwa 0,2 µm und die Siliziumnitridschicht (3B) mit einer Stärke von etwa 0,1 µm aufgebracht werden.

6. Verfahren nach einem der Ansprüche 1 bis 5, **dadurch**
**gekennzeichnet, dass**
in dem fünften Schritt als Barrierenmetall (10) Titan in einer Stärke von maximal 0,1 µm abgeschieden wird.

7. Verfahren nach einem der Ansprüche 1 bis 6,
bei dem die Halbleiterschicht (2) Silizium ist und
das Hoch-Barrieren-Metall (4) nach dem Aufbringen siliziert wird.

## Claims

1. Method for producing Schottky diodes having a protective ring, produced by deposition of metal, in the edge region of a Schottky contact formed on a semiconductor layer (2),
**characterized in that**
in a first step, a masking layer (3A) is produced, in a second step, a covering layer (3B) is produced onto the masking layer,
in a third step, the covering layer is patterned, a region provided for the Schottky contact being defined at the surface (9) of the semiconductor layer (2),
in a fourth step, the masking layer is etched back by undercutting, the region at the surface (9) of the semiconductor layer (2) being uncovered between the residual parts of the masking layer,
in a fifth step, a barrier metal (10) provided for the Schottky contact is deposited over the whole area, a ring (13) remaining free on the surface (9) of the semiconductor layer (2) between the masking layer (3A) and edges (8) of the barrier metal (10), and
in a sixth step, a high barrier metal (4) provided for the protective ring is deposited, the ring (13) being covered.

2. Method according to Claim 1,
**characterized in that**
in the sixth step, platinum is applied as the high barrier metal (4).

3. Method according to Claim 1 or 2,
**characterized in that**
in the sixth step, the high barrier metal (4) is applied to a thickness of approximately 0.1 µm.

4. Method according to one of Claims 1 to 3,
**characterized in that**
in the first step, a silicon oxide layer (3A) and, in the second step, on top of that, a silicon nitride layer (3B) are applied and patterned, and **in that**, in the fourth step, overhanging rims (15) of the nitride layer are formed by the undercutting.

5. Method according to Claim 4,
**characterized in that**
the silicon oxide layer (3A) is applied with a thickness of approximately 0.2 µm and the silicon nitride layer (3B) is applied with a thickness of approximately 0.1 µm.

6. Method according to one of Claims 1 to 5,
**characterized in that**
in the fifth step, titanium is deposited as the barrier metal (10) to a thickness of at most 0.1 µm.

7. Method according to one of Claims 1 to 6,
in which the semiconductor layer (2) is silicon and the high barrier metal (4) is siliconized after being applied.

## Revendications

1. Procédé de production de diodes Schottky qui ont, dans la partie marginale d'un contact Schottky formé sur une couche (2) semi-conductrice, un anneau de protection produit par un dépôt de métal,
**caractérisé en ce que**
on produit, dans un premier stade, une couche (3A) de masquage,
on produit, dans un deuxième stade, une couche (3B) de revêtement sur la couche de masquage,
on structure la couche de revêtement dans un troisième stade en définissant, à la surface (9) de la couche (2) semi-conductrice, une partie prévue pour le contact Schottky,
on attaque en retrait, dans un quatrième stade, la couche de masquage par attaque par en dessous en mettant à nu la partie sur la surface (9) de la couche (2) semi-conductrice comprise entre les parties restantes de la couche de masquage,
on dépose sur toute la surface, dans un cinquième stade, un métal (10) barrière prévu pour le contact Schottky en laissant à nu un anneau (13) à la surface (9) de la couche (2) semi-conductrice entre la couche (3A) de masquage et des bords (8) du métal (10) barrière, et
on dépose, dans un sixième stade, un métal (4) de barrière haute prévu pour l'anneau de protection en recouvrant l'anneau (13).

2. Procédé suivant la revendication 1,
**caractérisé en ce que**
l'on dépose du platine, dans le sixième stade, comme métal (4) de barrière haute.

3. Procédé suivant la revendication 1 ou 2,
**caractérisé en ce que**
l'on dépose, dans le sixième stade, le métal (4) de barrière haute en une épaisseur d'environ 0,1 µm.

4. Procédé suivant l'une des revendications 1 à 3,
**caractérisé en ce que**
l'on dépose et structure, dans le premier stade, une couche (3A) d'oxyde de silicium et, dans le deuxième stade, au-dessus, une couche (3B) de nitrure de silicium, et **en ce que** l'on forme dans le quatrième stade, par attaque par en dessous, des rebords (15) en une couche de nitrure en saillie.

5. Procédé suivant la revendication 4,
**caractérisé en ce que**
l'on dépose la couche (3A) d'oxyde de silicium en une épaisseur d'environ 0,2 µm et la couche (3B) de nitrure de silicium en une épaisseur d'environ 0,1 µm.

6. Procédé suivant l'une des revendications 1 à 5,
**caractérisé en ce que**
l'on dépose dans le cinquième stade, comme métal (10) barrière, du titane en une épaisseur de 0,1 µm au maximum.

7. Procédé suivant l'une des revendications 1 à 6,
dans lequel la couche (2) semi-conductrice est en silicium et on silicie le métal (4) de barrière haute après le dépôt.
